# EUROPÄISCHE PATENTANMELDUNG

(11) **EP 1 746 429 A1**
(43) Veröffentlichungstag der Anmeldung: **24.01.2007**
(21) Anmeldenummer: 06014785.7
(22) Anmeldetag: 15.07.2006
(51) Int. Cl.: G01R 31/28

(54) **Vorrichtung zum Prüfen von integrierten Halbleiterschaltkreisen auf Wafern und Verwendung der Vorrichtung**

(30) Priorität: 23.07.2005 DE 102005034475
(71) Anmelder: ATMEL Germany GmbH, 74072 Heilbronn (DE)
(72) Erfinder: Rittberger, Klaus, 71711 Steinheim (DE); Wieczorek, Heinrich, 74172 Obereisesheim (DE)

(57) **Zusammenfassung**

Vorrichtung zum Prüfen von integrierten Halbleiterschaltkreisen auf Wafern mit einer Messkarte (4) mit elektronischen Schaltungsanlagen zur Funktionskontrolle der auf den Wafern (3) angeordneten integrierten Halbleiterschaltkreise (6) und einem mit der Messkarte (4) verbundenen Testkopf (1) mit Kontaktnadeln (2), der einen elektrischen Kontakt zwischen der Messkarte (4) und den integrierten Halbleiterschaltkreisen (6) herstellt, wobei an der Vorrichtung wenigstens ein Düsenstock (9) mit wenigstens einer Düse (9a) zur Einleitung eines Gases im Wesentlichen senkrecht zur Oberfläche des Wafers vorgesehen ist und der Düsenstock (9) formschlüssig mit der Messkarte (4) verbunden ist.

## Beschreibung

Die vorliegende Erfindung betrifft eine Vorrichtung zum Prüfen von integrierten Halbleiterschaltkreisen auf Wafern, gemäß dem Oberbegriff des Patentanspruchs 1.

Nach der Fertigstellung von integrierten Halbleiterschaltkreisen werden diese in einem Testschritt einer Funktionskontrolle unterzogen, während sie noch im Wafer integriert sind, also vor ihrer Vereinzelung. Das Verhältnis von brauchbaren zur Gesamtzahl aller auf einem Wafer vorhandenen elektronischen Bauelemente wird als "Die Yield" bezeichnet und ist eine wichtige Kennzahl zur Beurteilung des Fertigungsprozesses und der Wirtschaftlichkeit einer Produktionslinie.
Eine Vorrichtung zum Testen der Wafer umfasst eine verschiebliche Tragvorrichtung, einen so genanten Chuck, auf dem der Wafer aufgelagert, mittels einer Vakuumpumpe angesaugt, fixiert und in x- ,y- und z- Richtung verschoben werden kann. Weiterhin enthält die Vorrichtung eine Messkarte, auf der elektronische Schaltungen angeordnet sind, mittels derer die Funktionsfähigkeit der integrierten Halbleiterschaltkreise auf dem Wafer überprüft werden kann. Auf der Unterseite der Messkarte und über einen Haltemechanismus mit dieser elektrisch leitend verbunden ist jeweils ein Testkopf mit federnden, haardünnen Kontaktnadeln angeordnet, welcher den elektrischen Kontakt zwischen Messkarte und den integrierten Halbleiterschaltkreisen auf dem Wafer herstellt. Dabei sind Messkarte und Testkopf mit einer Öffnung versehen, in die die Kontaktnadeln hineinragen. Diese sind ihrer Zahl und Anordnung nach jeweils an die zu testenden Halbleiterschaltkreise und den dadurch festgelegten Kontaktflächen angepasst. Wenn der Wafer mit Hilfe der verschieblichen Tragevorrichtung unterhalb der Kontaktnadeln des Testkopfes an der Stelle positioniert worden ist, wo die Kontaktflächen liegen, wird die Tragevorrichtung nach oben gefahren (z-Position) und die Kontaktflächen der Halbleiterschaltkreise werden mit einem speziellen Anpressdruck gegen die Kontaktnadelspitzen gedrückt. Während der Kontaktierung senden die elektronischen Schaltungen auf der Messkarte Testsignale aus und werten die Antwortsignale, die von den einzelnen auf dem Wafer angeordneten integrierten Halbleiterschaltkreisen zurückkommen, aus. Weiterhin werden im Zuge der Funktionskontrolle Spannung und Stromfluss in den Halbleiterschaltkreisen geprüft.
Nach Überprüfung der Funktion eines integrierten Halbleiterschaltkreises wird die Tragevorrichtung mit dem Wafer jeweils zum nächsten Bauelement weiter verschoben und dieser erneut kontaktiert.

Typischerweise bestehen die Kontaktflächen eines elektronischen Bauelements auf einem Wafer aus metallischem Material, wie beispielsweise Aluminium, welches an Luft eine Oxidschicht an seiner Oberfläche bildet. Beim Andrücken der Kontaktnadeln an die Kontaktfläche muss diese Metalloxidschicht, die eine Dicke von mehreren µm aufweist, überwunden werden, dabei werden besonders die Kontaktnadelspitzen mechanisch beansprucht und unterliegen daher einem Verschleiß, der ihre Lebensdauer begrenzt. In der Praxis hat sich gezeigt, dass die Spitzen der Kontaktnadeln nach einigen Prüfvorgängen oxidieren oder Deformationen aufweisen und insbesondere Ablagerungen an den Kontaktnadelspitzen den Übergangswiderstand erhöhen.

Bei derzeit üblichen Verfahren müssen die Kontaktnadeln regelmäßig gereinigt oder ausgetauscht werden. Während dieser Zeit steht die gesamte Vorrichtung zum Prüfen still. Es bedeutet, dass die Messkarte mit dem Testkopf und den gebrauchten Kontaktnadeln entnommen werden und ein neuer Testkopf eingesetzt werden muss.

Weiterhin sind aus der gegenwärtigen Praxis zur Erhöhung der Messsicherheit verschiedene Reinigungsmethoden für die Spitzen der Kontaktnadeln, wie Zwischenkontaktieren der Kontaktnadeln auf Klebefolien oder der Einsatz von Reinigungswafern bekannt. Allerdings liegt der Nachteil dieser Verfahren darin, dass Prüfzeit der Wafer insgesamt verlängert wird, was zu hohen Kosten führt.

Um die Standzeit der Kontaktnadeln zu erhöhen, wurden auch unterschiedliche Materialien für deren Herstellung verwendet. Üblicherweise sind die Nadeln aus Wolframstahl oder einer Kupfer-Beryllium-Legierung gefertigt. Aus der DE 101 50 291 A1 ist jedoch auch bekannt, die Spitzen der Kontaktnadeln oder ihre gesamte Oberfläche mit einem harten Material, wie Titannitrid, zu versehen.

Nachteil der bisherigen Verfahren ist, dass diese jeweils zeitintensiv oder aufgrund der Verwendung teurer Materialien und Herstellungsverfahren sehr kostspielig sind.

Daher ist es Aufgabe der Erfindung, unter Vermeidung vorgenanter Nachteile die Standzeit der Kontaktnadeln und die Messsicherheit der Prüfvorrichtung zu erhöhen.

Diese Aufgabe wird erfindungsgemäß durch eine Vorrichtung der eingangs genannten Art mit den Merkmalen des Patentanspruches 1 gelöst. Günstige Ausgestaltungsformen sind Gegenstand von Unteransprüchen.

Demnach besteht das Wesen der Erfindung darin, dass bei einer Vorrichtung zum Prüfen von integrierten Halbleiterschaltkreisen auf Wafern, die eine Messkarte zur Funktionskontrolle der auf den Wafern angeordneten integrierten Halbleiterschaltkreisen und einen mit der Messkarte verbundenen Testkopf mit Kontaktnadeln, der einen elektrischen Kontakt zwischen der Messkarte und den integrierten Halbleiterschaltkreisen herstellt, umfasst, an der Vorrichtung wenigstens ein Düsenstock mit wenigstens einer Düse zur Einleitung eines Gases in den Bereich des Testkopfes vorgesehen ist, wobei der Düsenstock formschlüssig mit der Messkarte verbunden ist.
Da die Anordnung und Anzahl der Kontaktnadeln, sowie die zugehörige Schaltungsanordnung auf der Messkarte und die Ausformung der Messkarte jeweils von den zu testenden Bauteilen abhängig sind, ändert sich mit den Halbleiterschaltkreisen auch die Geometrie der Prüfvorrichtungen. Auch der Düsenstock ist der jeweiligen Geometrie der Vorrichtung angepasst und so ausgestaltet, dass ein Formschluss zwischen Messkarte und Düsenstock entsteht.

In einer Weiterbildung der Erfindung ist zur Einleitung ein inertes Gas, vorzugsweise Stickstoff vorgesehen. Durch die Verdrängung der Luft um den Prüfbereich des Wafers, ergeben sich bei der Funktionskontrolle mehrere Vorteile gleichzeitig.
Zum einen ist der Kontaktwiderstand an den Kontaktflächen der integrierten Halbleiterschaltkreise geringer, da die Oxidation der Kontaktflächen im Bereich der Kontaktierung wesentlich reduziert wird. Weiterhin befinden sich durch den Zustrom des Gases nur sehr wenige lonen und polare Moleküle (H₂O) im Bereich der Kontaktflächen, was sich vorteilhaft auf die Isolationseigenschaften der Oberfläche zwischen den Kontaktflächen auswirkt.
Grundsätzlich ergibt sich wegen der vorhandenen Restleitfähigkeit der Oberfläche eine Parallelschaltung von Widerständen bei der Funktionskontrolle, wobei diese aus dem Widerstand an der Oberfläche zwischen den zu messenden Kontaktflächen und dem Widerstand der zu messenden Schaltungsteile im Substrat des Wafers besteht. Tatsächlich sollen jedoch nur die elektrischen Eigenschaften der Schaltungsteile im Substrat des Wafers analysiert werden. Je höher daher der Widerstand zwischen den zu messenden Kontaktflächen ist, umso eher kann der Einfluss der Leitfähigkeit der Oberfläche vernachlässigt werden und hierdurch auch bei hochohmigen Messungen die elektrischen Eigenschaften der zu messenden Schaltungsteile beurteilt werden.

Gemäß einer vorteilhaften Ausgestaltung der Erfindung umströmt das Gas die Kontaktnadeln des Testkopfes während der Funktionskontrolle laminar.
Somit werden Verwirbelungen zwischen dem inerten Gas und der Normalatmosphäre, die die Testergebnisse verfälschen können, vermieden.

Gemäß einer Weiterbildung der Erfindung ist es besonders vorteilhaft, ein austauschbares Zwischenstück zwischen Düsenstock und Messkarte vorzusehen, um den unterschiedlichen geometrischen Ausführungen der Messkarten und deren Öffnungen, sowie Abständen zwischen Messkarte und Wafer gerecht zu werden. Das austauschbare Zwischenstück lässt sich über den Düsenstock, der vorzugsweise zylindrisch geformt ist, schieben. Somit kann an allen Messkarten immer derselbe Düsenstock verwendet werden. Das austauschbare Zwischenstück erlaubt eine preiswerte und schnelle Anpassung der Vorrichtung an unterschiedliche Ausführungen der Messkarten.

Weiterhin durchdringt gemäß einer Weiterbildung der Erfindung der Düsenstock die Messkarte im Bereich einer Öffnung, die für den Testkopf mit den Kontaktnadeln vorgesehen ist und ist innerhalb der Öffnung im Wesentlichen mittig angeordnet. Somit befindet sich die Düse oberhalb der Spitzen der Kontaktnadeln. Hierdurch werden die Kontaktnadelspitzen durch das vorbeiströmende Gas zusätzlich gekühlt und Ablagerungen vermieden.

Eine weitere Ausgestaltung sieht vor, dass der Düsenstock die Öffnung an der Messkarte verschließt. Dies hat den Vorteil, dass das zuströmende inerte Gas nicht nach oben in den Raum der Vorrichtung, der oberhalb der Messkarte liegt, entweichen kann und somit eine hohe Gaskonzentration im Bereich der Kontaktflächen der zu prüfenden Halbleiterschaltkreise und Kontaktnadeln vorherrscht.

Eine Weiterbildung der Erfindung sieht vor, dass der Düsenstock mehrstükkig ausgeführt ist. Dadurch lässt sich der Düsenstock an unterschiedliche Messanordnungen bzw. geometrische Verhältnisse leicht anpassen und die Einzelteile des Düsenstocks entsprechend den vorgegebenen Abmessungen zusammensetzen.

Bei unterschiedlichen Temperaturbeanspruchungen ist üblicherweise eine Nachjustierung der Vorrichtung, insbesondere der Messkarte und des Testkopfs mit den Kontaktnadeln, erforderlich. Gemäß einer vorteilhaften Ausgestaltung ist daher vorgesehen, dass der Düsenstock an der Vorrichtung höhenverstellbar gehalten ist. Dadurch kann ein Höhenausgleich zwischen Düsenstock und der Messkarte stattfinden.

Gemäß einer Weiterbildung der Erfindung ist dabei ein Außengewinde am Düsenstock vorgesehen. Der Vorteil dieser Ausführung besteht darin, dass auf einfache und schnelle Art eine Feinjustierung des Düsenstocks an der Vorrichtung möglich ist, was bei wechselnden Temperaturen aufgrund der Längenänderungen der einzelnen Bauteile an der Vorrichtung erforderlich wird, um die Maßtoleranzen während der Funktionskontrolle einhalten zu können

Eine Weiterbildung der Erfindung sieht Mittel zur Steuerung des Durchflusses des Gases durch die Düse vor. Der Vorteil dieser Ausgestaltung liegt darin, dass diese Mittel, die vorzugsweise aus einer elektronischen Steuerschaltung bestehen, den Durchfluss des Gases in Abhängigkeit von vorgegebenen Parametern wie beispielsweise Temperatur oder Luftfeuchtigkeit regeln und dadurch für optimale Verhältnisse im Bereich der Kontaktflächen und Kontaktnadeln gesorgt werden kann.

Anhand der Figuren soll die Erfindung näher beschrieben werden.
Fig. 1 zeigt einen Schnitt durch einen Testkopf mit Kontaktnadeln beim Abtasten eines Wafers
Fig. 2 zeigt eine Draufsicht auf einen Testkopf mit Kontaktnadeln beim Abtasten eines Wafers
Fig. 3 zeigt eine perspektivische Darstellung eines Testkopfes mit Kontaktnadeln beim Abtasten eines Wafers
Fig. 4 zeigt einen Schnitt durch einen Düsenstock und dessen Befestigung an einer Vorrichtung zum Prüfen von integrierten Halbleiterschaltkreisen auf Wafern
Fig. 5 zeigt einen Längsschnitt durch die Vorrichtung zum Prüfen von integrierten Halbleiterschaltkreisen auf Wafern.

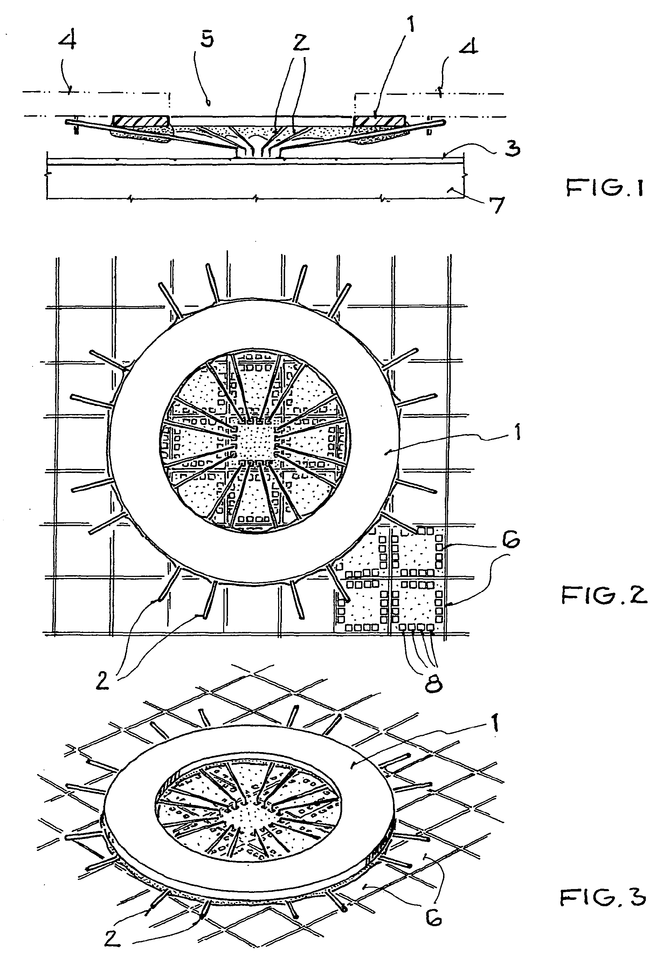

Fig. 1 zeigt einen Schnitt durch einen Testkopf 1 mit Kontaktnadeln 2 beim Abtasten eines Wafers 3, der auf einer Tragevorrichtung 7 aufliegt. Der Testkopf 1 ist an der Unterseite einer Messkarte 4, welche nur schematisch dargestellt ist, befestigt und mit dieser elektrisch leitend verbunden. Die Messkarte besitzt üblicherweise eine kreisrunde Öffnung 5, die den Blick von oben auf den Bereich der Kontaktnadeln 2 freigibt.

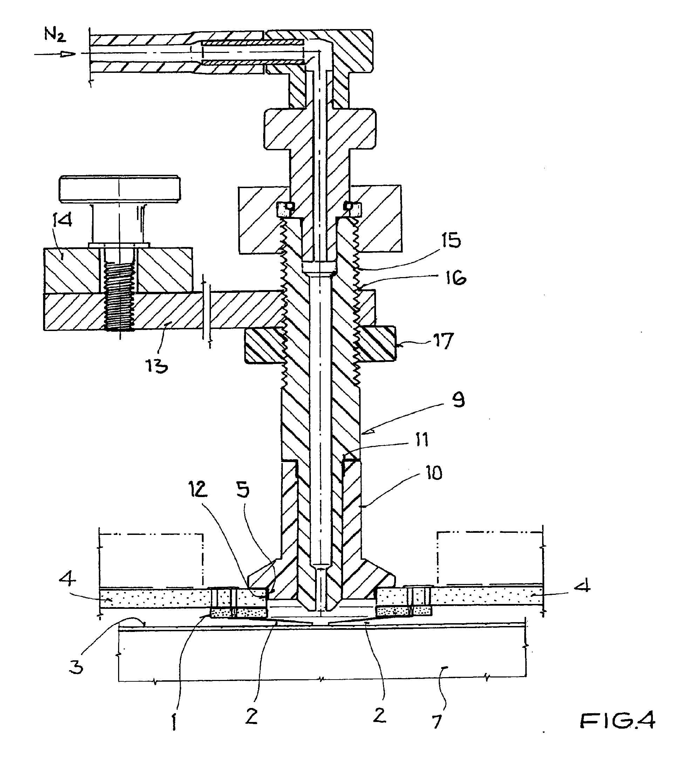

Die Draufsicht auf den Testkopf 1 in Fig. 2 und dessen perspektivische Darstellung Fig. 3 zeigen schematisch mehrere Bauelemente integrierter Halbleiterschaltkreise 6 auf dem Wafer 3 und die Anordnung von Kontaktflächen 8, die von den Kontaktnadeln 2 abgetastet werden. Die Anordnung und Anzahl der Kontaktnadeln 2, sowie die zugehörige Schaltungsanordnung auf der Messkarte und die Ausformung der Messkarte 4 selbst sind hierbei jeweils von den zu testenden elektronischen Bauelementen abhängig.

Fig. 4 zeigt einen Schnitt durch einen Düsestock 9 und dessen Befestigung an einer Vorrichtung zum Prüfen von integrierten Schaltkreisen auf Wafern 18. Gemäß einer vorteilhaften Ausgestaltung der Erfindung durchdringt der Düsenstock 9 die Messkarte 4, wobei durch die Düse 9a Stickstoff in den Bereich des Testkopfes 1 oberhalb der Kontaktnadeln 2 eingeleitet wird. Die Wanddicke des Düsenstocks 9, der einen kreisförmigen Querschnitt besitzt, nimmt in einem Bereich oberhalb der Austrittsöffnung sprunghaft ab, so dass ein Falz 11 entsteht. Über den Teil des Düsenstocks 9 mit verringerter Wanddicke ist ein austauschbareres Zwischenstück 10 geschoben, das am Falz 11 anliegt und somit fixiert ist. Das austauschbare Zwischenstück 10 erweitert sich im unteren, der Messkarte 4 zugewandten Bereich stetig und überdeckt die kreisförmige Öffnung 5 der Messkarte 4. An der Unterseite des austauschbaren Zwischenstücks 10 ist ebenfalls ein Falz 12 vorgesehen, wobei der Durchmesser des verbleibenden Querschnitts des austauschbaren Zwischenstücks 10 dem Durchmesser der kreisförmigen Öffnung 5 der Messkarte 4 entspricht und somit zwischen Düsenstock 9 und der Messkarte 4 eine formschlüssige Passung entsteht.
Der Düsenstock 9 ist über einen Ausleger 13 mit einer Brücke 14 der Prüfvorrichtung 18 verschraubt. Während der Ausleger 13 fest mit der Prüfvorrichtung 18 verbunden ist, ist die Düse 9 am Ausleger 13 höhenverstellbar gehalten. Hierzu ist die Düse 9 mit einem Außengewinde 15 und der Ausleger 13 mit einer Gewindebohrung 16 versehen. Die Fixierung erfolgt mittels einer Kontermutter 17. Aufgrund dieser Ausgestaltung kann der Düsenstock 9 sowohl an unterschiedliche Abstände zwischen Prüfvorrichtung und Wafer 3, die sich aus unterschiedlichen Messkarten 4 und Schaltungsanordnungen darauf ergeben, angepasst werden, als auch bei unterschiedlichen Temperaturbeanspruchungen während des Prüfvorgangs und den damit einhergehenden Längenänderungen nachjustiert werden.

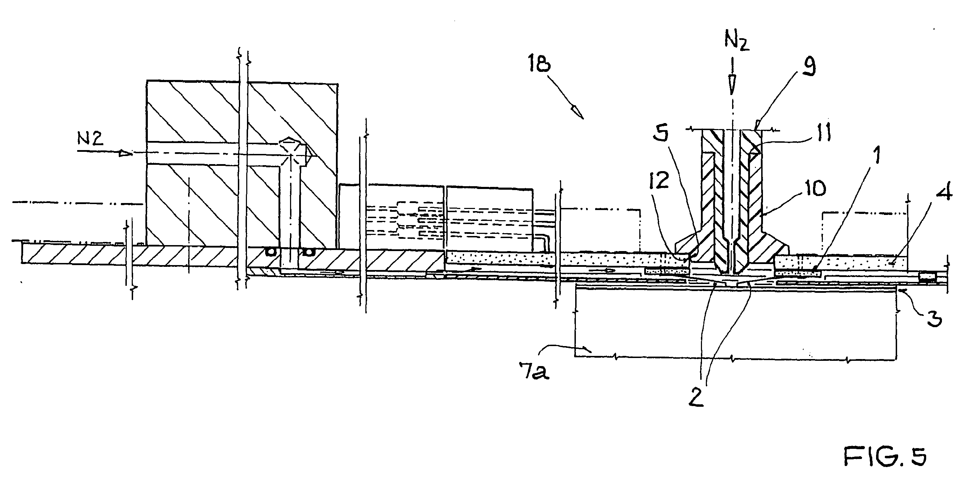

Fig. 5 zeigt einen Längsschnitt durch die Prüfvorrichtung 18. Gemäß einer besonders vorteilhaften Ausführung wird der Wafer 3 während der Funktionskontrolle mittels einer heizbaren Tragevorrichtung eines so genannten Hotchucks 7a erhitzt, so dass die Adhäsion von Wasser auf der Oberfläche des Wafers 3 weiter verringert wird. Die anschließende oder gleichzeitige Spülung des Bereichs um den Testkopf 1 mit einem inerten Gas trägt zu einer hohen Messsicherheit bei. Während die Restleitfähigkeit der Oberfläche zwischen den jeweiligen Kontaktflächen auf ein Minimum reduziert wird, tritt zusätzlich durch das einströmende Gas ein Kühleffekt für die übrigen Bauteile der Prüfvorrichtung 18, insbesondere der Kontaktnadeln, ein.

### Bezugszeichenliste

- 1: Testkopf
- 2: Kontaktnadeln
- 2a: Kontaktnadelspitze
- 3: Wafer
- 4: Messkarte
- 5: Öffnung
- 6: Elektronische Bauelemente
- 7: Tragevorrichtung
- 7a: Hotchuck
- 8: Kontaktfläche
- 9: Düse
- 10: Zwischenstück
- 11: Falz - Düsenstock
- 12: Falz - Zwischenstück
- 13: Ausleger
- 14: Brücke
- 15: Außengewinde
- 16: Gewindebohrung
- 17: Kontermutter
- 18: Vorrichtung - Prober

## Patentansprüche

1. Vorrichtung zum Prüfen von integrierten Halbleiterschaltkreisen auf Wafern umfassend
• eine Messkarte (4) mit elektronischen Schaltungsanlagen zur Funktionskontrolle der auf den Wafern (3) angeordneten integrierten Halbleiterschaltkreise (6)
• einen mit der Messkarte (4) verbundenen Testkopf (1) mit Kontaktnadeln (2), der einen elektrischen Kontakt zwischen der Messkarte (4) und den integrierten Halbleiterschaltkreisen (6) herstellt,
**dadurch gekennzeichnet, dass**
• an der Vorrichtung wenigstens ein Düsenstock (9) mit wenigstens einer Düse (9a) zur Einleitung eines Gases im Wesentlichen senkrecht zur Oberfläche des Wafers vorgesehen ist, wobei der Düsenstock (9) formschlüssig mit der Messkarte (4) verbunden ist.

2. Vorrichtung gemäß Anspruch 1, **dadurch gekennzeichnet, dass** der Düsenstock (9) die Messkarte (4) im Bereich einer Öffnung (5) durchdringt, die für den Testkopf (1) mit den Kontaktnadeln (2) vorgesehen ist und innerhalb der Öffnung (5) im Wesentlichen mittig angeordnet ist.

3. Vorrichtung gemäß Anspruch 2, **dadurch gekennzeichnet, dass** der Düsenstock (9) als im Wesentlichen dichter Verschluss für die Öffnung (5) der Messkarte (4) vorgesehen ist.

4. Vorrichtung gemäß einem der Ansprüche 1 bis 3, **dadurch gekennzeichnet, dass** der Düsenstock (9) mehrstückig ausgeführt ist.

5. Vorrichtung gemäß einem der Ansprüche 1 bis 4, **dadurch gekennzeichnet, dass** zur formschlüssigen Verbindung mit der Messkarte (4) am Düsenstock (9) mindestens ein austauschbares Zwischenstück (10) vorgesehen ist.

6. Vorrichtung gemäß einem der Ansprüche 1 bis 5, **dadurch gekennzeichnet, dass** der Düsenstock (9) an der Vorrichtung (18) höhenverstellbar gehalten ist.

7. Vorrichtung gemäß einem der Ansprüche 1 bis 6, **dadurch gekennzeichnet, dass** ein Außengewinde am Düsenstock (9) vorgesehen ist.

8. Verwendung der Vorrichtung gemäß einem der Ansprüche 1 bis 7 zur Einleitung eines inerten Gas, vorzugsweise Stickstoff.
